# EUROPEAN PATENT APPLICATION

(11) **EP 0 571 236 A1**
(43) Date of publication of application: **24.11.1993**
(21) Application number: 93303993.5
(22) Date of filing: 21.05.1993
(51) Int. Cl.: H01M 2/22, H01M 6/42, H05K 3/06

(54) **Flexible welding board for battery pack**

(30) Priority: 22.05.1992 US 886869
(71) Applicant: ALEXANDER MANUFACTURING COMPANY, Mason City, Iowa 50401 (US)
(72) Inventor: Alexandres, Richard B., Clear Lake, IA 50428 (US); Villenponteaux, George W., Mason City, IA 50401 (US)
(74) Representative: Parr, Ronald Edward R.E. Parr & Co.

(57) **Abstract**

A flexible welding board for a battery pack, which is a polyester film or polymer with prepunched holes and a laminated metal or metal material. The polyester film with a suitable polymer adhesive or other adhesive includes a laminated metal other than nickel thereon. The metal alloy or metal is subsequently imaged with a pattern, and etched providing a flexible welding board for the welding of components of a battery pack, including the battery cells, electrical components and the electromechanical components which are spot-welded thereto. The entire process can be done robotically providing a battery pack which has electromechanical integrity between the battery cells, components, flexible welding board and the battery pack housing.

## Description

The present invention relates to flexible welding boards, to processes of making them and to battery packs comprising the boards and one or more battery cells. In particular, though not exclusively, the invention relates to flexible welding boards including a metal sheet or other member which allows for the welding thereto of battery cells, (for example nickel-cadmium (NiCad) battery cells) electrical components and electromechanical components, directly to the flexible welding board. The welding is preferably by spot-welding.

In the past, battery packs, particularly nickel-cadmium battery packs, have been assembled by hand, the batteries being spot-welded to each other by flat straps, such as stainless steel or nickel. Then, the contacts are placed into a battery pack housing, and the batteries are connected by spot-welding the flat straps to the battery contacts. Finally, electrical or electromechanical components such as thermistors, resistors, capacitors and any other components are connected to the straps or the contacts, such as by spot-welding or soldering. This type of process is labor intensive, taking considerable time and motion by a group of individuals to assemble each battery pack.

Flexible circuits proposed in the prior art were sometimes not practical, as the circuits could sometimes not be easily mass-produced, nor
could they sometimes be easily spot-welded. Prior art flexible circuits were not able to include all of the components, including the battery cells, the electrical components and the electromechanical components such as the battery casing contacts. Prior art flex circuits did not lend themselves to mass production for use in NiCad or other types of battery packs.

Prior art flexible circuits were usually a copper material on a polymer. Prior to etching of the copper material, the copper had to sometimes be protected, such as by plating with a tin lead or a tin nickel. This was an additional time consuming step which added expense and labor.

Prior art standard flexible boards require soldering metal weld tabs to the board to allow battery cells to be welded to it thus adding expense and labor.

The present invention overcomes the disadvantages of the prior art by providing a flexible welding board where the electrical components and electromechanical components can be spot-welded to the board, for example a polyester board, for subsequent insertion into a battery housing or battery casing to form a battery pack. The elimination of the labor intensive operations of adding weld tabs prior to welding results in a significant cost saving , as well as allowing a more compact board design. The welding board can be, for example, a bare-backed welding board.

Accordingly, in a first aspect the present invention provides a flexible welding board (10) for use in the production of a battery pack, characterised in that the board comprises:
a polymer substrate (18); and
one or more members (12, 14, 16) of metal other than nickel alloys secured to the substrate; and
the board can be bent, folded or otherwise deformed along pre-determined lines or zones so as to accommodate a battery cell or cells in the production of the battery pack.

In its preferred forms the present invention comprises a flexible welding board of a metal laminated onto a deformable shape-retaining polyester or polymer film with a co-extruded polymer adhesive or other suitable adhesive or material therebetween for inclusion within a battery pack. The electrical components and the electromechanical components can be directly welding onto the metal of the flexible circuit board followed by placement inside a polymer casing thereby forming a battery pack. The flexible welding board lends itself to mass production, particularly silk screening techniques, photographically imaged techniques and etching techniques for forming the electrical circuit pattern on metal foil laminated to the polymer film.

According to one embodiment of the present invention, there is provided a flexible bare back welding board for a battery pack including a polymer film, a polyester film or polymer film base, having apertures formed at the welding locations, suitable co-extruded or other adhesives or materials, and a laminated metal. The metal can be silk screen printed or lithographed on a laminated resist film applied to the metal with electrical circuit patterns, etched with suitable chemicals, and subsequently processed to provide a welding pattern of the metal on the polymer film for subsequent electrical and electromechanical assembly, including battery cells, and electrical and electromechanical components to produce a battery pack. The battery cells, electrical components, electromechanical components and the flexible welding are positioned in a polymer casing, including the contacts which can be spot-welded to the flexible welding board to produce the battery pack.

Significant aspects and features of the present invention provide a flexible welding board for a battery pack, such as a battery pack which can be spot-welded.

Another significant aspect and feature of the present invention is a flexible welding board which is adaptable to robotic manufacturing processes and robotic welding processes. The nickel alloy or other metal alloy or metal material particularly lends itself to spot-welding.

A further significant aspect and feature of the present invention is a flexible welding board such as polyester composition which provides for the attachment of electrical components, including battery cells, resistors, capacitors and thermistors, as well as electromechanical components such as battery pack contacts for battery chargers where the battery pack contacts mount within the polymer casing of the battery housing and are spot welded directly to the flexible welding board.

A further significant aspect and feature of the present invention is a flexible welding board having nickel alloy or other metal alloy battery interconnection straps and at least two contacts adhesively secured to a polymer or polyester flexible base. The base is so dimensioned and the contacts and straps so oriented and dimensioned such that automatic alignment of the straps and contacts with the battery terminals is effected when the base is formed about a battery pack.

A still further significant aspect and feature of the present invention is that the flexible welding board can be fabricated as individual boards on a continuous strip with discrete multiple circuit patterns formed thereon at spaced intervals. The strips with the boards temporarily attached thereto can be coiled for continuous processing. The strips can be formed in a process line and will retain the formed shape. This feature is particularly desirable in facilitating the placement of battery cells within the formed welding board.

Preferred forms of the present invention show the following advantages:
(a) the flexible welding board is suitable for a battery pack for use in a portable radio or any other electrical or electronic device.
(b) the flexible welding board can be readily manufactured using automated etching processes.

There are now described, by way of example and with reference to the accompanying drawings, a flexible welding board, a process of producing it, and
a battery pack as preferred embodiments of the present invention.

In the drawings:
FIG. 1 is a plan view of the flexible welding board, in a planar, unfolded disposition;
FIG. 2 illustrates the battery pack comprising the flexible welding board of Figure 1 folded to embrace battery cells of size AA, the view being a section on the line 2-2 of Figure 1;
FIG.3 is a front view of the battery pack of Figure 2;
FIG. 4 is a back view of the battery pack of Figure 2; and
FIG. 5 is an exploded view of the battery pack including a housing back (bottom) half (24), the battery pack (36) comprising the flexible welding board and battery cells and a housing front (top) half (28).

The flexible welding board referred to in the following description with reference to the accompanying drawings can be, for example, a bare-backed welding board.

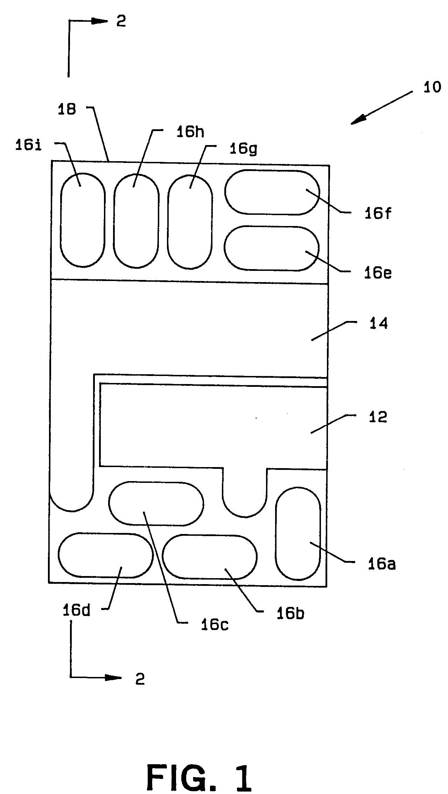

FIG. 1 illustrates a plan view of a flexible welding board 10 including a plus pad 12, a minus pad 14, and battery straps 16a-16n, all of which are adhesively secured to a polyester base 18, as later described in detail. The battery straps 16a-16n accommodate a plurality of cells, such as AA cells, by way of example and for purposes of illustration only, and not to be construed as limiting of the present invention. Any other size battery cell can be utilized. The battery cells can be alkaline, mercury, NiCad, or any other suitable type of cells. The battery straps 16a-16n wrap around the alternating cells, and in this instance, provide a 15 volt disposable alkaline battery for an electronic product, such as a portable radio such as a Handie-Talkie FM radio, also referred to as an "HT". An assembly of the cells and the bare back flexible welding board then engages into a molded plastic housing. The large flat rectangular portions forin the contact pad points through holes in the molded polymer housing as later described in detail. The principals and teachings of the present invention can pertain to any other types of battery cells, and any other types of electrical and electromechanical configurations. The battery straps 16a-16n are spot-welded onto the ends of each cell, and the spot-welding occurs through holes in polyester film 18 to engage and make contact with the appropriate end of the cell, as later described in detail. Usually, it only takes two spot-welding electrodes to make contact, but in this instance, three or more spot-welding electrodes may be preferable for efficient electromechanical contact and for the appropriate surface area contact for current flow between the battery straps and the batteries. The metal battery strap material is a nickel or stainless steel alloy or other suitable metal alloy. This alloy of nickel or other material is laminated to a polyester film of a suitable thickness with a suitable adhesive. Any suitable metal alloy or metal can be utilized as well as any suitable base material such as a polymer base or any other type of base material as well as any material therebetween for sticking the numbers together.

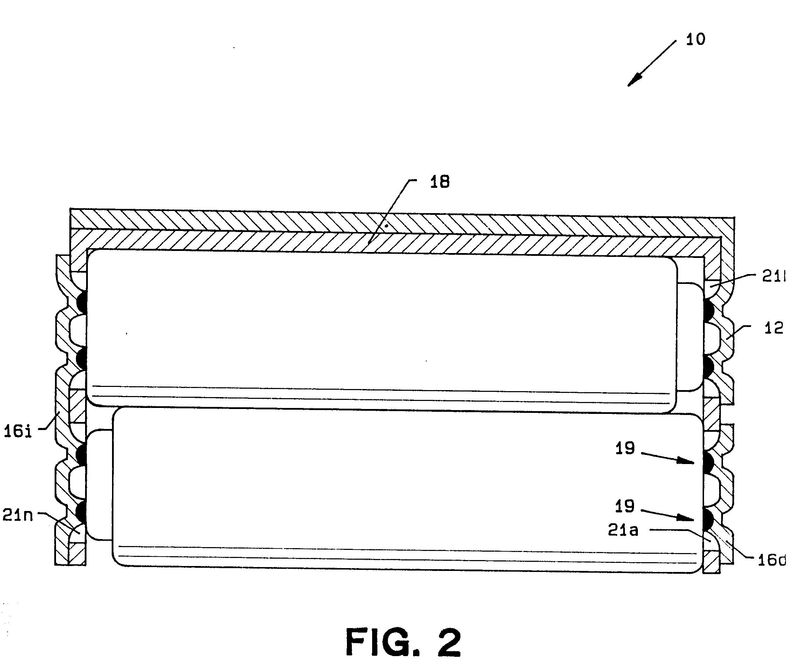

FIG. 2 illustrates an end view of the flexible bare backed welding board 10 including the polyester film 18, the adhesive which could be a co-extruded adhesive 20, and the battery straps 16a-16n. Two cells are appropriately positioned and spot welded to the straps of the flexible welding board 10. A typical weld 19 is made through the straps 16a-16n through the plurality of holes 21a-21n in the polyester film 18. The dimensions are exaggerated to appropriately illustrate the teachings of this patent.

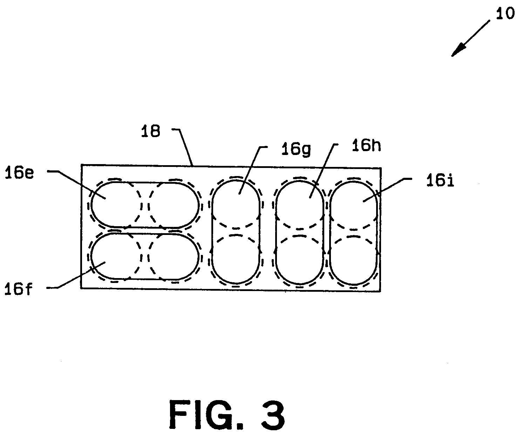

FIG. 3 illustrates a front view of the flexible bare backed welding board 10 engaged about battery cells of alternating size AA cells in place. All other numerals correspond to those elements previously described.

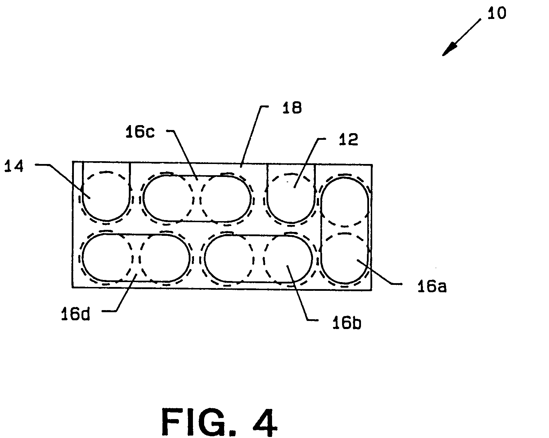

FIG. 4 illustrates a back view of the flexible welding board 10 of FIG. 2. All numerals correspond to those elements previously described, including the alternating battery cells.

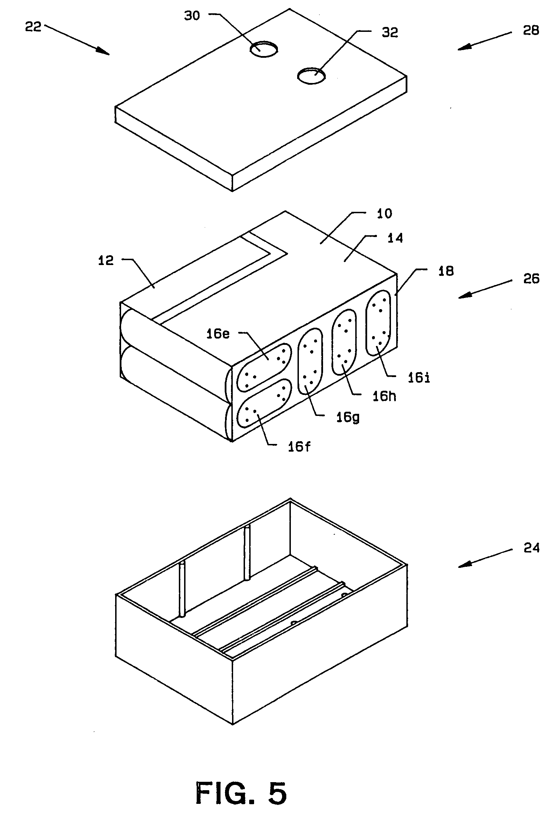

FIG. 5 illustrates an exploded view of a front view of a battery pack 22, including a back half 24. A flexible welding board 10 with the batteries forming a battery assembly 26, and a front view of the front half 28 of the battery pack 22. All numerals correspond to those elements previously described. The back half 24 of the battery pack 22 is essentially a small, rectangular box. The front half 28 of the battery pack 22 includes two holes 30 add 32 which provide for engagement of the contact plates of the flexible welding board 10 with the contact fingers of a Handie-Talkie radio when the battery pack 22 is inserted into the battery compartment of the Handie-Talkie radio. Other electrical or electromechanical components can be spot-welded to the flexible welding board 10, such as battery contacts, thermistors, thermal activated switches, diodes, or any other components.

### MODE OF OPERATION

The flexible welding board 10 is manufactured by processes so that the welding alloy geometrical configuration remains on the polyester film 18 after the processing steps. Representative processing steps are now described below.
1.a. The hole pattern for the bare backed board is first punched through the substrate film by use of a press, and a die constructed with shrink allowances for the material built into the die.
1.b. The circuit pattern is either laminated with dry resist film, with respect to the holes in the substrate film, or the circuit pattern is silk-screened onto the nickel alloy or other metal alloy or metal and then processed in a conventiorial manner. Either method is an acceptable process for laying out the circuit pattern of resist material on the alloy.
2. The nickel alloy or-other alloy or metal is then processed in a suitable processing station, and particularly lends itself to horizontal processing with a plurality of stations. What is advantageous is that the material can be done in a reel-to-reel processing fashion because of the steps of laying out the resist pattern onto the nickel alloy or other metal alloy or metal material, which can be repetitive or can change on a long length of material, and then the material can be coiled at the input end and the output end of a processor.
3. The process station would include an etch chamber, a cascade rinse chamber, a fresh water rinse chamber, an inspection station, a spray stripping solution station for removal of the resist material, a fresh water rinse station, and a blower drying station.
4. The etch chamber uses a ferric chloride solution, which is a combination of ferric chloride and hydrochloric acid. Any other suitable etching solution is also acceptable. This particularly lends itself to etching of the nickel alloy or other metal alloy or metal and is advantageous because the ferric chloride etching solution is inexpensive, environmentally and economically preferred, and readily etches the nickel alloy or other metal alloy or metal. Any suitable caustic solution can be used to remove the resist over the welding board pattern which remains after the etching away of the nickel alloy or other alloy which was not coated with resist. After processing, the flexible welding board can be cut apart, such as on a paper cutter, or punched apart such as on a punch press. Alternatively, individual welding boards fabricated in form and subsequently removed after processing. The teachings of the present invention include a process to manufacture product of a flexible welding board, which can be for large sized battery packs, such as for HTs, to small sized battery packs, such as for Flip-Phones.

The product of the flexible welding board 10 of FIG. 1 is manufactured by the new and novel recognition that the nickel alloy or other metal alloy can be adhesively secured to the polyester film 18, which can then include spot-welded electrical or electromechanical components, including but not limited to the components selected from the group of: battery cells, resistors, capacitors, thermal cutouts, thermistors, diodes, jumper wires, battery contacts and any other electrical or electromechanical components.

Various modifications can be made to the present invention without departing from the apparent scope hereof.

The flexible welding board referred to herein is flexible, at least, to an extent such that it can be deformed, for example by hand or by machine, to a shape suitable to accommodate battery cells in production of a battery pack of the invention. If desired, the flexible welding board need be "flexible" only to an extent such that such deformation occurs substantially only along pre-determined lines or zones; the laminate or other structure of which the welding board is composed need not per se be flexible.

The term "metal" as used herein includes metal alloys. The metal is conveniently one having relevant properties similar to nickel alloy; such a metal is stainless steel.

The polyester (or other polymer) substrate can be, for example, in the form of a film coating, sheet or other layer. Where the polyester (or other polymer) substrate is said to be "with a co-extruded adhesive" the substrate can, for example, have been formed by extrusion concurrently with the adhesive so that a surface (or part of a surface) of the substrate is coated with the adhesive.

Preferred forms of the invention have one or more of the following features:
(a)-the polymer substrate is a layer of a polyester.
(b)- the metal member is in sheet form and is laminated to the substrate.
(c)-in the process of the invention a subsequent step in which at least one battery cell is welded to the metal.

The term "flexible welding board" as used herein includes flexible welding substrates in general, irrespective of rigidity, thickness, shape or other features commonly associated with the word "board".

## Claims

1. A flexible welding board (10) for use in the production of a battery pack, characterised in that the board comprises:
a polymer substrate (18); and
one or more members (12, 14, 16) of metal other than nickel alloys secured to the substrate; and
the board can be bent, folded or otherwise deformed along pre-determined lines or zones so as to accommodate a battery cell or cells in the production of the battery pack.

2. A flexible welding board according to Claim 1, wherein the metal members are spaced apart electrical conductors.

3. A flexible welding board according to Claim 1 or 2, wherein the metal and polymer substrate have been laminated together by means of a layer of an adhesive between them, said layer having been formed on the polymer substrate by a co-extrusion method.

4. A flexible welding board comprising:
(a) a polyester film with a co-extruded adhesive; and
(b) at least one strip or other sheet of metal other than nickel alloy, the sheet having a pre-determined configuration and being laminated to said polyester film.

5. A flexible welding board according to any of the preceding claims, wherein flexibility in the board is provided by one or more lines or other zones therein along which the board can be folded so as to accommodate one or more battery cells.

6. A flexible welding board according to any of the preceding claims, wherein the polymer substrate has formed therein apertures to facilitate securement of the metal member or members to one or more battery cells.

7. A process of producing a flexible welding board for a battery pack, characterised in that it comprises the steps of:
(a) laminating one or more members of metal other than nickel alloys to a polymer substrate by means of an adhesive;
(b) printing a resist of an electrical circuit pattern onto said metal;
(c) etching away unprotected metal; and
(d) removing said resist to expose said electrical circuit pattern.

8. A battery pack which comprises:
a flexible welding board as claimed in any of Claims 1 to 6, and one or more battery cells secured to the board, the board being folded, bent or otherwise deformed so as to accommodate the cells.

9. A battery pack according to Claim 8, wherein the flexible welding board comprises a laminate of a polyester layer and a layer of metal other than nickel alloys, the board being folded so that the polyester layer nests within the metal layer, and the polyester layer having apertures formed therein through which the battery cells are secured by welds to the metal layer.

10. A battery pack comprising:
(a) a plurality of predetermined geometrical configurations of metal other than nickel alloys adhesively secured to a polyester film;
(b) a plurality of battery cells spot-welded to said metal; and
(c) a polymer housing for encompassing said battery cells, said metal and said film.
